# EUROPEAN PATENT APPLICATION

(11) **EP 2 234 151 A1**
(43) Date of publication of application: **29.09.2010**
(21) Application number: 10156488.8
(22) Date of filing: 15.03.2010
(51) Int. Cl.: H01L 23/367, H01L 27/146, H05K 1/02

(54) **Semiconductor device**

(30) Priority: 24.03.2009 JP 2009072496
(71) Applicant: Sony Corporation, Tokyo 108-0075 (JP)
(72) Inventor: Amano, Ryosuke, Tokyo 108-0075 (JP)
(74) Representative: Beder, Jens

(57) **Abstract**

A semiconductor device (1) includes: a semiconductor element (2) having an imaging function, one surface (2a) of which serves as a light-receiving surface; a package (3) having a recess (3a) containing the semiconductor element (2) with the light-receiving surface (2a) facing outward; a light-transmitting plate (5) closing the recess (3a) of the package (3) containing the semiconductor element (2); a conductor (4) provided at the package (3), electrically connected to the semiconductor element (2), and electrically connected to an external circuit; a heat conductive member (6) provided to protrude from another surface of the semiconductor element (2); and a printed circuit board (7) on which the external circuit is provided, on which the semiconductor element (2) is mounted in electrical connection with the external circuit, and which is formed with an opening (7b) to serve as a clearance for the heat conductive member (6).

## Description

### BACKGROUND OF THE INVENTION

### 1. Field of the Invention

The present invention relates to semiconductor devices having high heat-radiating properties and including a semiconductor element having an imaging function contained in a package.

### 2. Description of the Related Art

JP-A-2007-194441 discloses a semiconductor device including a semiconductor element having an imaging function such as a CCD (charge coupled device) and a CMOS image sensor provided in a package formed of ceramic. Referring to JP-A-2007-194441 more specifically, a photoconductor element and a semiconductor element are provided one over another in a concave package, and a heat-conductive plate disposed between the photoconductor element and the semiconductor element is connected to a heat conductor exposed inside and outside the package. In the semiconductor device disclosed in JP-A-2007-194441, improved heat radiation is achieved by forming a heat transfer path having high heat conductivity which transfers heat from both of the semiconductor element and the photoconductor element to the heat-conductive plate and the heat conductor sequentially.

In the semiconductor device disclosed in JP-A-2007-194441, one end of the heat conductor exposed inside and outside the package is connected to a printed board to radiate heat finally. In the case of a semiconductor device used as an image sensor, since a light-receiving surface of the device serves as an optical path, no heat-radiating member can be disposed on the light-receiving surface. For this reason, the semiconductor device disclosed in JP-A-2007-194441 cannot be forcibly cooled by providing a cooling element such as a cooling fan above the semiconductor element as done for a CPU (central processing unit) of a computer.

In the case of a semiconductor device having an imaging function, in general, the dark current of the device is substantially doubled by an increase of 8 to 10°C in the device temperature even if the temperature does not exceed a rated temperature beyond which reliability can be affected. Thus, image quality can be degraded by increased noises. For this reason, it is quit important to use a semiconductor device having an imaging function with the temperature of the device kept as low as possible in order to achieve satisfactory image quality.

### SUMMARY OF THE INVENTION

It is desirable to provide a semiconductor device having high heat radiating properties in which the above-described problems are solved.

It is also desirable to provide a semiconductor device in which degradation of image quality attributable to a temperature rise can be prevented.

According to an embodiment of the invention, there is provided a semiconductor device including a semiconductor element having an imaging function, one surface of which serves as a light-receiving surface, a package having a recess containing the semiconductor element with the light-receiving surface facing outward, a light-transmitting plate closing the recess of the package containing the semiconductor element, a conductor provided at the package, electrically connected to the semiconductor element, and electrically connected to an external circuit, a heat conductive member provided to protrude from another surface of the semiconductor element, and a printed circuit board on which the external circuit is provided, on which the semiconductor element is mounted in electrical connection with the external circuit, and which is formed with an opening to serve as a clearance for the heat conductive member.

According to the embodiment of the invention, the heat conductive member is provided to protrude from one surface of the semiconductor element, and the printed circuit board is formed with an opening to serve as a clearance for the heat conductive member. Therefore, heat generated at the semiconductor element is can be efficiently radiated by the heat conductive member without being transferred to the printed circuit board. Thus, the degradation of image quality attributable to a temperature rise can be prevented.

### BRIEF DESCRIPTION OF THE DRAWINGS

Fig. 1 is a plan view of major parts of a semiconductor device according to a first embodiment of the invention;
Fig. 2 is a sectional view of the major parts of the semiconductor device;
Fig. 3 is a perspective view of an assembly obtained by combining a semiconductor element, a light-transmitting plate, and a heat conductive member with a package, taken on the side of the assembly where the heat conductive member is provided;
Fig. 4 is a sectional view showing a way to mount the heat conductive member in a mounting recess of the package;
Fig. 5 is an exploded perspective view of the semiconductor device and the heat-radiating member;
Fig. 6 is a sectional view of the semiconductor device having the heat-radiating member mounted thereon;
Fig. 7 is a sectional view of a semiconductor device according to a second embodiment of the invention, showing a way to secure a heat-radiating member on a heat conductive member;
Fig. 8 is a perspective view showing the heat conductive member with screw holes formed on a top surface thereof;
Fig. 9 is a sectional view of a semiconductor device according to a third embodiment of the invention, showing how to secure a heat-radiating member using screws provided on a heat conductive member;
Fig. 10 is a perspective view of the heat conductive member with screws formed on a top surface thereof;
Fig. 11 is a sectional view of a semiconductor device according to a fourth embodiment of the invention, showing a heat conductive member having an earth cable connected therewith;
Fig. 12 is an enlarged sectional view of the major parts showing a way to electrically connect the heat conductive member to a ground potential of a semiconductor element and to electrically connect the heat conductive member to a ground potential of a printed circuit board using the earth cable;
Fig. 13 is a plan view showing a way to connect the semiconductor element to a through hole;
Fig. 14 is an enlarged sectional view of the major parts showing a way to connect the earth cable to the heat conductive member using welding;
Fig. 15 is a sectional view of major parts of a semiconductor device according to a fifth embodiment of the invention, showing a Peltier element stacked on a heat conductive member and a cooling fan provided for the same;
Fig. 16 is a sectional view showing the Peltier element stacked on the heat conductive member with the thickness of the heat conductive member reduced;
Fig. 17 is a sectional view of the embodiment in an alternative arrangement in which the Peltier element is substituted for the heat conductive member;
Fig. 18 is an exposed perspective view of a semiconductor device according to a sixth embodiment of the invention in which a semiconductor element is directly placed on a heat conductive member;
Fig. 19 is a plan view showing a relationship between the semiconductor element and the heat conductive member;
Fig. 20 is a sectional view of the major parts showing a way to place the semiconductor element directly on the heat conductive member and to mount it to a package; and
Fig. 21A is a sectional view showing a positional relationship between conductors on a QFP (quad flat package) type package and a heat conductive member; and Fig. 21B is a sectional view showing a positional relationship between conductors on a BGA (ball grid array) type package and a heat conductive member.

### DETAILED DESCRIPTION OF THE INVENTION

Semiconductor devices embodying the invention will now be described as listed below with reference to the drawings.
1. First Embodiment
2. Second Embodiment
3. Third Embodiment
4. Fourth Embodiment
5. Fifth Embodiment
6. Sixth Embodiment
7. Other Embodiments
8. Exemplary Applications

### (First Embodiment)

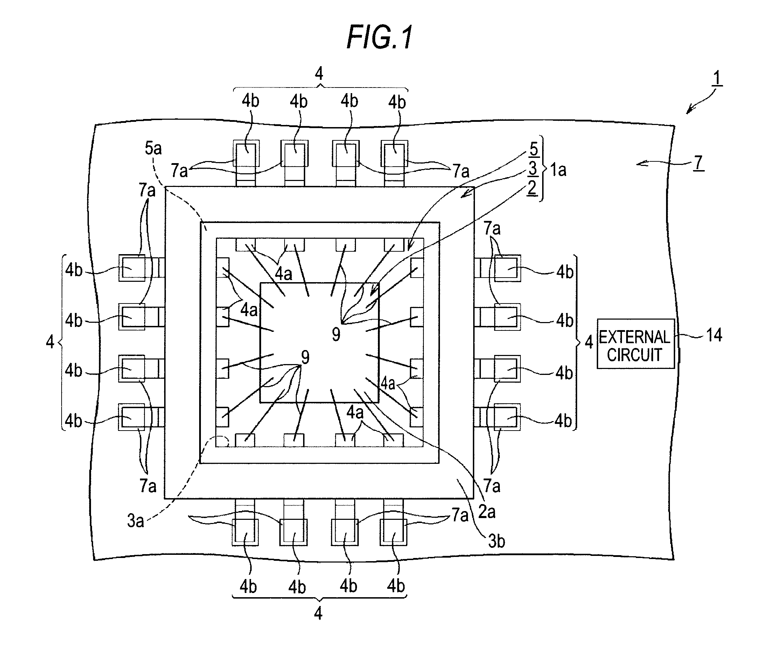

As shown in Figs. 1 to 4, a semiconductor device 1 embodying the invention includes a semiconductor element 2 of, for example, QFP (quad flat package) type having an imaging function, a package containing the semiconductor element 2, conductors 4 electrically connected to the semiconductor element 2, a light transmitting plate 5 closing the package 3, a heat conductive member 6 provided to protrude from a surface of the semiconductor element 2, and a printed circuit board 7 having an external circuit provided thereon.

The semiconductor element 2 is a light-receiving element having an imaging function such as a CCD (charge coupled device) or a CMOS image sensor, and the element has a light-receiving portion formed on one surface of a substrate thereof made of, for example, silicon, the light-receiving portion constituting a light-receiving surface 2a.

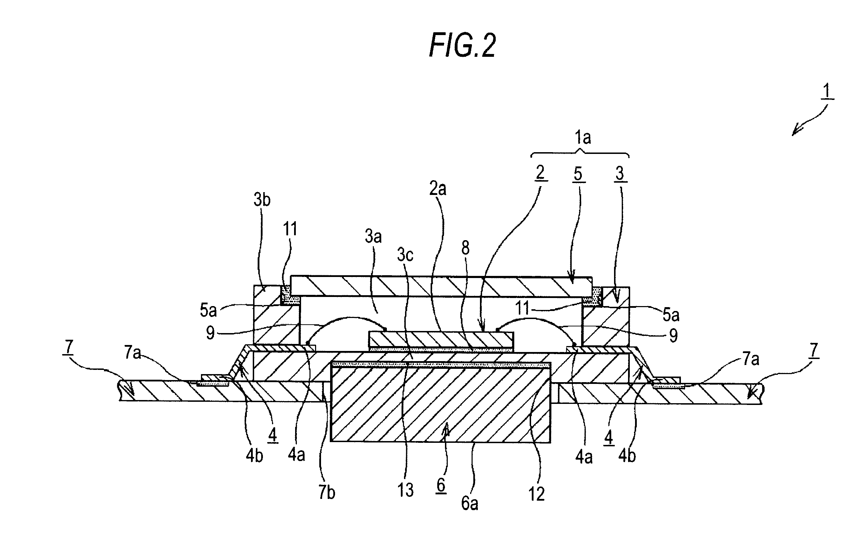

As shown in Fig. 2, the semiconductor element 2 is contained in the package 3. The package 3 is formed from an electrical insulating material such as ceramic or epoxy resin. The package 3 has, for example, a substantially rectangular shape, and a recess 3a with a bottom having, for example, a substantially rectangular shape is formed on one side of the package. The above-described semiconductor element 2 is mounted in the recess 3a such that the light-receiving surface 2a is located on the open side of the recess. For example, the semiconductor element 2 is applied to the bottom of the recess 3a using an adhesive having low heat resistance, e.g., a heat conductive adhesive 8.

As shown in Figs. 1 and 2, the conductors 4 which are lead wires of the semiconductor element 2 are provided on a circumferential wall 3b forming part of the recess 3a, the conductors extending through the circumferential wall 3b from the inside of the same to the outside. Specifically, a plurality of conductors 4 are provided side by side on each side of the package 3. The semiconductor element 2 is electrically connected to ends 4a of the conductors 4 located inside the recess 3a, and the external circuit on the printed circuit board 7 is electrically connected to ends 4b of the conductors 4 located outside the recess 3a. The conductors 4 are bent such that the ends 4b thereof located outside the recess 3a become lower than the ends 4a thereof located inside the recess 3a to put the ends 4b in contact with lands on the printed circuit board 7 which is located under the package 3. The ends 4a of the conductors 4 located inside the recess 3a are electrically connected to terminals of the semiconductor element 2 by wires 9.

A plurality of semiconductor elements 2 may be contained in the recess 3a of the package 3. When there is a plurality of semiconductor elements 2, a semiconductor element 2 to serve as a light receiving element may be secured to another semiconductor element integrated with a driving control circuit or the like for the light-receiving element using an adhesive, a surface of the former element opposite to a light-receiving surface 2a being secured to the latter element. In this case, the second semiconductor element located under the light-receiving element is also electrically connected to the ends 4a of the conductors 4 by wires. When there is a plurality of semiconductor elements 2, the semiconductor elements 2 may be horizontally arranged side by side. The semiconductor elements 2 may be mounted on a pattern formed on a package 3 on a flip-chip basis.

When the semiconductor element 2 is secured to the recess 3a of the package 3 and bonded to the conductors 4, the recess 3a is closed by the light transmitting plate 5. In general, the light-transmitting plate 5 is constituted by a transparent glass plate or resin plate. The light-transmitting plate 5 may be an element having optical functions such as a low-pass filter or a lens. A step 5a is formed at the top of the circumferential wall 3b forming part of the recess 3a to allow the light-transmitting plate 5 to be positioned and mounted in the recess. The light-transmitting plate 5 is secured by fitting it to the step 5a with an adhesive 11 applied to the step 5a or the periphery of the light-transmitting plate 5.

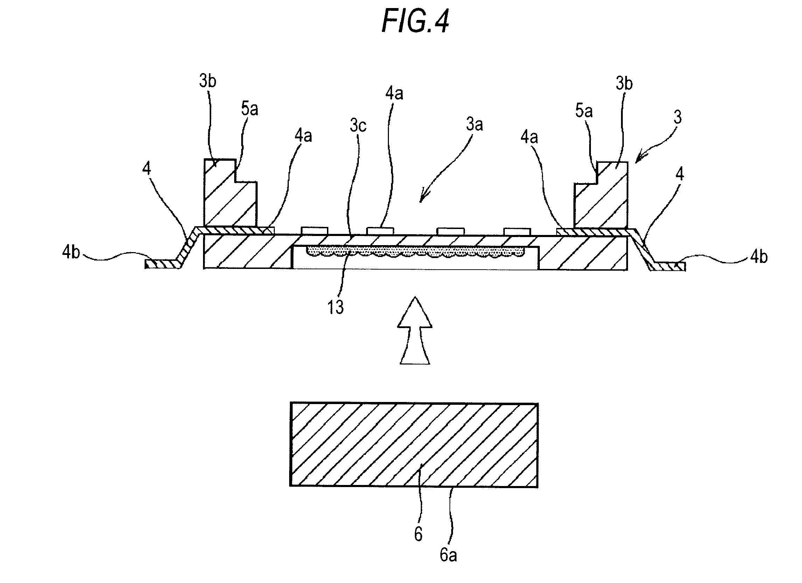

As shown in Figs. 2 and 4, the package 3 has a mounting recess 12 formed on a bottom surface thereof opposite to the recess 3a to allow the heat conductive member 6 to be mounted. The mounting recess 12 is formed in a position in which the recess 3a is substantially opposite to the semiconductor element 2 secured to the step 3a. Therefore, the bottom part of the package 3 is smaller in thickness than the peripheral part of the same because the mounting recess 12 is formed on the other side. The package 3 is formed from an electrical insulating material such as ceramic or epoxy resin as described above, and such materials have high heat resistance in general. Therefore, the package 3 is formed with a small thickness in the region where the semiconductor element 2 is secured than in the periphery of the package to allow heat generated at the semiconductor element 2 to be thermally transferred to the heat conductive member 6 having low heat resistance with high efficiency. A bottom portion 3c having a small thickness is left in the region where the mounting recess 12 is provided to prevent electrical insulation between the heat conductive member 6 and the semiconductor element 2 from being degraded, thereby preventing operational problems.

Referring to the size of the mounting recess 12, the area of the mounting recess 12 may be slightly greater or smaller than the area of the semiconductor element 2 as long as the area is substantially the same as the area of the semiconductor element 2. It is not necessarily required to provide the mounting recess 12 when the thickness of the bottom of the package 3 is sufficiently small without the recess.

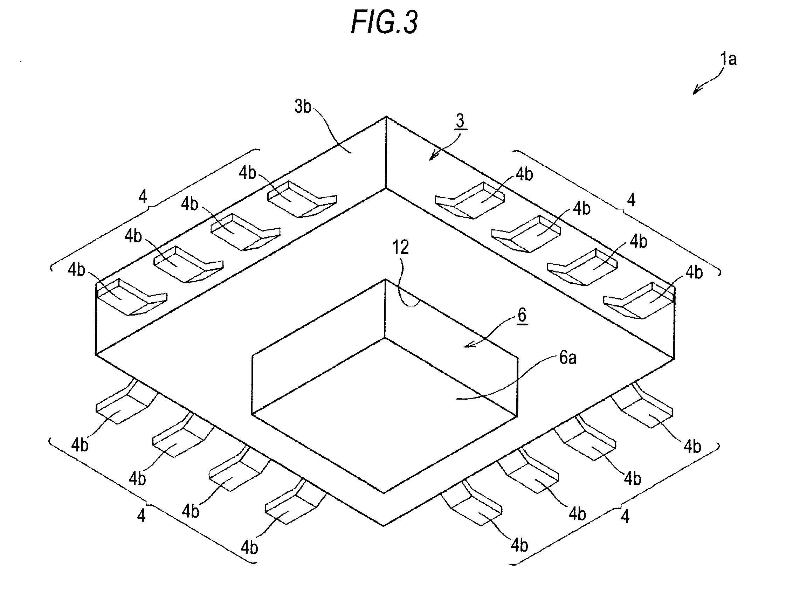

As shown in Figs. 3 and 4, the heat conductive member 6 is mounted in the mounting recess 12. The heat conductive member 6 is made of a material which is excellent at least in heat conductivity. For example, a copper tungsten alloy may be used. The heat conductive member 6 is applied to the mounting recess 12 using a heat conductive adhesive 13. The heat conductive member 6 is formed with such a height that it protrudes from the bottom of the package 3 when the heat conductive member 6 is applied to the mounting recess 12. More specifically, the heat conductive member 6 is formed to protrude to such a height that a top surface 6a of the member is located below the ends 4b of the conductors 4 located outside the recess 3a.

The material of the heat conductive member 6 is not limited to copper tungsten alloys, and other iron-type metals such as copper alloys may alternatively be used.

The semiconductor device 1 is fabricated by applying the semiconductor element 2 to the recess 3a of the package 3 having the conductors 4 provided therein and electrically connecting the element to the ends 4a of the conductors located inside the recess 3a of the package 3 by wire bonding. The recess 3a is closed by the light-transmitting plate 5, and the heat conductive member 6 is applied to the mounting recess 12 as shown in Fig. 4. Thereafter, an assembly 1a formed by combining the semiconductor element 2, the light-transmitting plate 5, and the heat conductive member 6 with the package 3 as thus described is mounted on the printed circuit board 7.

For example, the printed circuit board 7 is a flexible printed circuit board having a thickness of, for example, about 1 mm as shown in Figs. 1 and 2. In the region where the assembly 1a is mounted, the printed circuit board 7 has pads 7a to which the ends 4b of the conductors 4 located outside the recess 3a are electrically connected. The pads 7a are provided in a quantity corresponding to the number of ends 4b of the conductors 4 located outside the recess 3a, and the pads are arranged substantially in the form of a rectangle. Each of the pads 7a is electrically connected to the external circuit 14 formed on the printed circuit board 7. In the region surrounded by the plurality of pads 7a, an opening 7b is formed to serve as a clearance for the heat conductive member 6 secured in the mounting recess 12 of the package 3 and protruding from the bottom of the package 3.

The printed circuit board 7 may be a rigid board or a flex-rigid printed circuit board which is a combination of a rigid board and a flexible board.

The assembly 1a formed by combining the package 3 with the semiconductor element 2, the light-transmitting plate 5, and the heat conductive member 6 is preliminarily secured in its mounting position on the printed circuit board 7 with the heat conductive member 6 inserted in the opening 7b. Thereafter, the ends 4b of the conductors 4 located outside the recess 3a are soldered to the pads 7a using a reflow process. The semiconductor device 1 formed by mounting the assembly 1a on the printed circuit board 7 is in a state in which the top surface 6a of the heat conductive member 6 protrudes from the opening 7b above the surface of the printed board opposite to the mounting surface having the pads 7a provided thereon. Therefore, heat generated at the semiconductor element 2 is thermally transferred to the heat conductive member 6 protruding above the surface of the printed circuit board 7 opposite to the mounting surface having the pads 7a provided thereon.

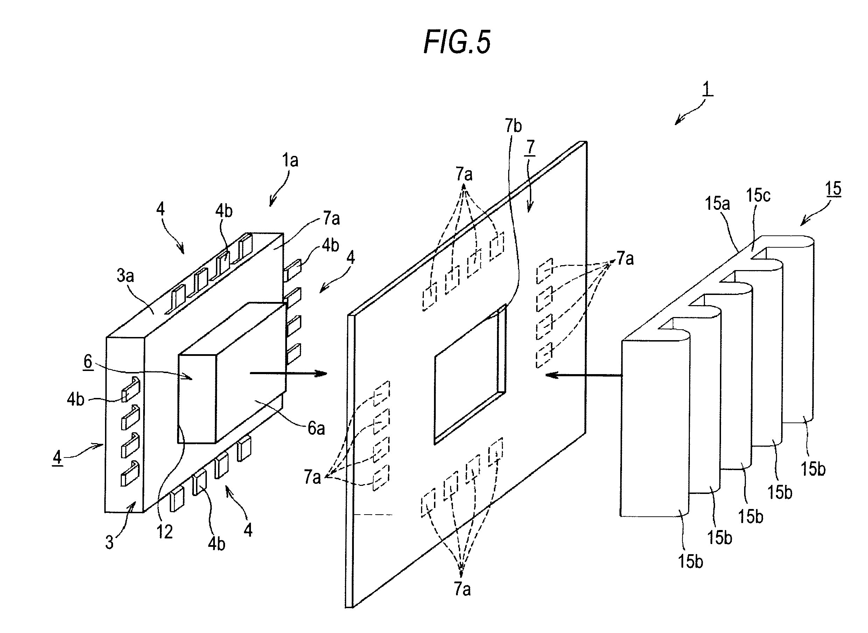

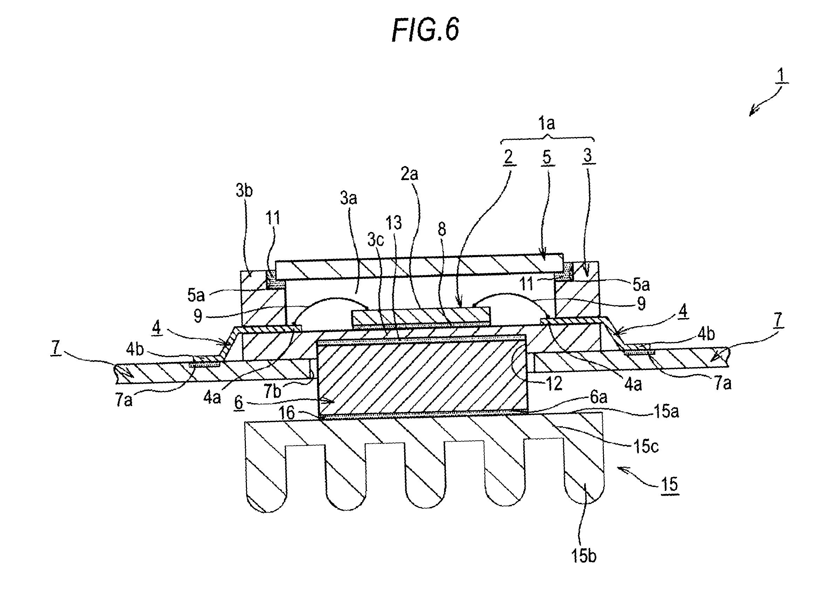

Further, the heat conductive member 6 of the semiconductor device 1 may be provided with a heat-radiating member 15 as shown in Figs. 5 and 6. The heat-radiating member 15 is formed from a metal material having high heat radiating properties such as aluminum. On surface of a base portion 15c of the heat-radiating member 15 is formed flatly to serves as an attaching surface 15a for attaching the member on the top surface 6a of the heat conductive member 6. The heat conductive member 6 has such a thickness that the top surface 6a is located above the printed circuit board 7 to allow the heat-radiating member 15 which is greater than the mounting recess 12 to be mounted on the same. The heat-radiating member 15 has a plurality of fins 15b formed on the side of the member opposite to the base portion 15c. The heat-radiating member 15 is secured to the heat conductive member 6 by attaching the attaching surface 15a to the top surface 6a of the heat conductive member 6 using a heat conductive adhesive 16 serving as a securing member.

In the above-described semiconductor device 1, most of the distance between the semiconductor element 2 and the heat-radiating member 15 is occupied by the thickness of the heat conductive member 6 which has low heat resistance. Therefore, in the semiconductor device 1, heat generated at the semiconductor element 2 can be transferred to the heat-radiating member 15 with very high efficiency, and the temperature of the semiconductor element 2 can consequently be kept low.

That is, in the semiconductor device 1, the heat of the semiconductor element 2 is efficiently transferred to the heat-radiating member 15 through the heat conductive member 6. Thus, the temperature of the semiconductor element 2 of the semiconductor device 1 can be kept low to suppress thermal noises caused by a dark current attributable to a temperature rise and irregularities of black levels in the screen (black shading). Since the temperature of the semiconductor element can be kept low, the life of the semiconductor element can be extended. Further, in the semiconductor device 1, the heat of the semiconductor element 2 can be discharged at the heat-radiating member 15 without intervention of the printed circuit board 7. Thus, a relatively small amount of heat is transferred to the printed circuit board 7. As a result, thermal stress exerted on electronic components mounted on the printed circuit board 7 other than the assembly 1a can be suppressed, and the failure rate of circuits including those components can be kept low.

In general, the material of the package 3 is different from the material of the printed circuit board 7, and the materials therefore have different linear expansion coefficients. In the semiconductor device 1, heat of the semiconductor element 2 can be efficiently radiated to suppress a temperature rise at the package 3. As a result, the printed circuit board 7 is less vulnerable to thermal contraction attributable to a change in the temperature thereof. Therefore, solder cracking is less likely to occur at the regions where the ends 4b of the conductors 4 located outside the recess 3a are soldered to the pads 7a, which allows the product to be improved in long term reliability.

### (Second Embodiment)

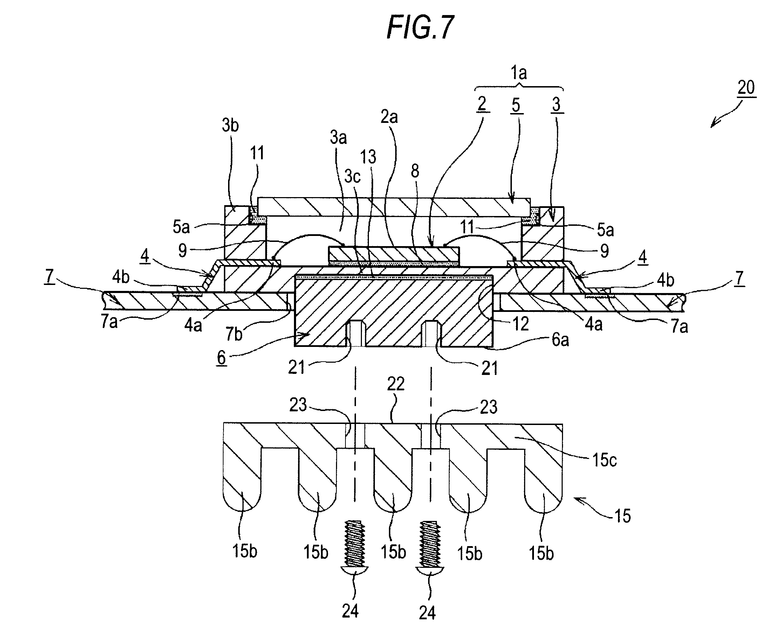

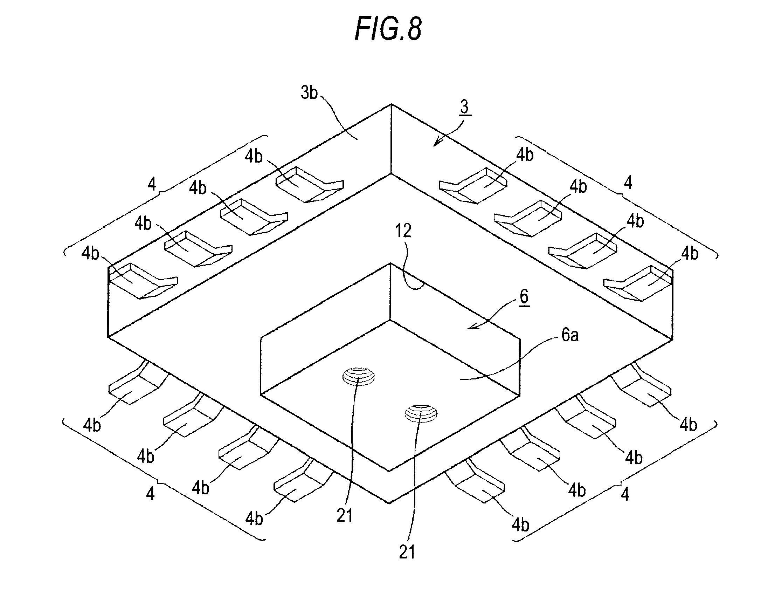

As shown in Figs. 7 and 8, in a semiconductor device 20 which will be described below, a heat-radiating member 15 is secured to a heat conductive member 6 using screws serving as securing members.

Specifically, one or plurality of screw holes 21 are provided on a top surface 6a of the heat conductive member 6, and two screw holes are provided in this embodiment.

The heat-radiating member 15 is formed from a metal material having high heat radiating properties such as aluminum. One surface of a base portion 15c of the member is formed flatly to serve as a surface 22 to abut on the top surface 6a of the heat conductive member 6. A plurality of fins 15b are formed on the other side of the base portion 15c. Through holes 23, 23 are formed between two respective pairs of adjoining fins 15b in association with the screw holes 21, 21 on the heat conductive member 6.

The heat-radiating member 15 is positioned by causing the abutting surface 22 to abut on the top surface 6a of the heat conductive member 6. Thereafter, screws 24, 24 to serve as securing members are inserted through the through holes 23, 23 and fastened into the screw holes 21 to secure the heat-radiating member 15 with the top surface 6a of the heat conductive member 6 and the abutting surface 22 kept in tight contact with each other.

In the above-described semiconductor device 20, the heat-radiating member 15 is secured to the heat conductive member 6 using the screws 24, which makes it possible to achieve anti-shock properties higher than those achieved when the member is secured using the heat conductive adhesive 16. The junction between the heat conductive member 6 and the heat-radiating member 15 undergoes great temperature changes when the device serves as a video camera because the device has a high temperature in operation and otherwise returns to a normal temperature. Since the heat-radiating member 15 is secured to the heat conductive member 6 by the screws 24, the strength of the junction against thermal stress can be kept higher than that achievable using the heat conductive adhesive 16. In case that the semiconductor device 20 must be disassembled and repaired to mend a failure, the device can be more easily disassembled and repaired when the heat-radiating member 15 is secured to the heat conductive member 6 using the screws 24 than when the heat-radiating member 15 is secured to the heat conductive member 6 using the heat conductive adhesive 16.

### (Third Embodiment)

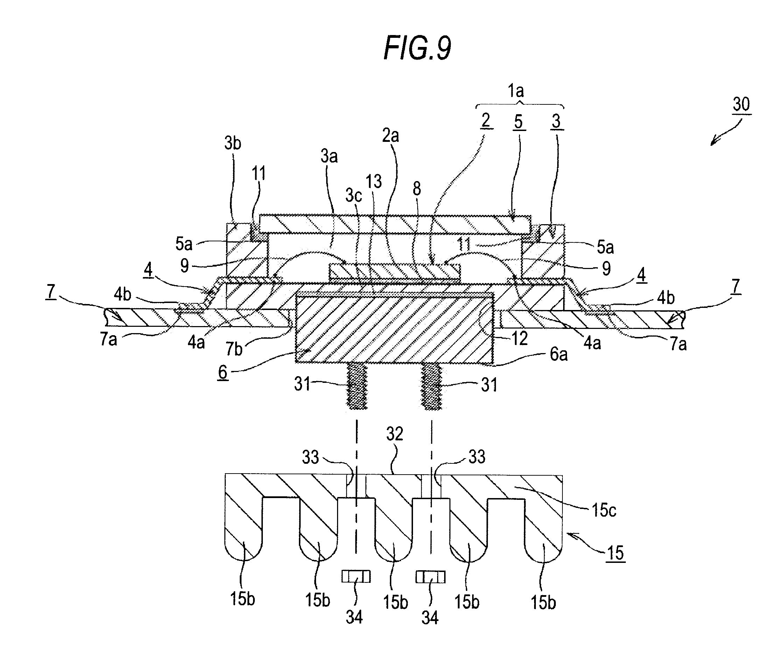

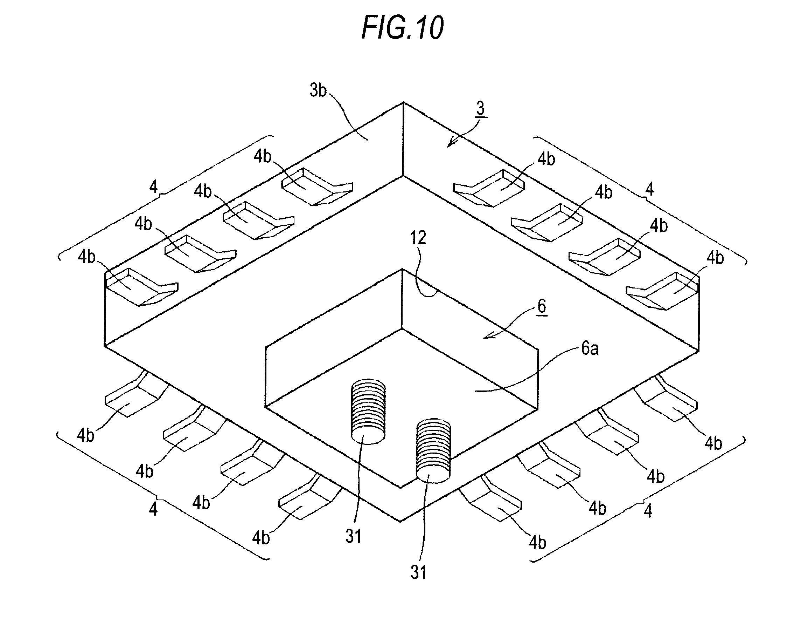

In a semiconductor device 30 described below, a heat conductive member 6 is provided with screws to serve as securing members as shown in Figs. 9 and 10, and a heat-radiating member 15 is secured by fastening the screws with nuts.

Specifically, screws 31 are provided integrally with a top surface 6a of the heat conductive member 6. One or a plurality of screws 31 may be provided, and two screws are provided in this embodiment.

The heat-radiating member 15 is formed from a metal material having high heat radiating properties such as aluminum. One surface of a base portion 15c of the member is formed flatly to serve as a surface 32 to abut on the top surface 6a of the heat conductive member 6. A plurality of fins 15b are formed on the other side of the base portion 15c. Through holes 33, 33 are formed between two respective pairs of adjoining fins 15b in association with the screws 31, 31 on the heat conductive member 6.

The heat-radiating member 15 is positioned by causing the abutting surface 32 to abut on the top surface 6a of the heat conductive member 6. Thereafter, screws 31, 31 to serve as securing members are inserted through the through holes 33, 33, and the screws 31, 31 are fastened with nuts 34, 34 to secure the heat-radiating member 15 with the top surface 6a of the heat conductive member 6 and the abutting surface 32 kept in tight contact with each other.

The above-described semiconductor device 30 can provide the following advantages in addition to the same advantages as provided by the above-described semiconductor device 20. Specifically, in the semiconductor device 20 shown in Figs. 7 and 8, the heat conductive member 6 is distorted toward the semiconductor element 2 when the screws 24 are fastened too strongly, and distortion can occur also in the semiconductor element 2 in the package 3. As a result, an offset can occur between the optical axis of the semiconductor element 2 and the optical axis of an optical lens disposed in a les barrel or the like. Then, an image imaged by the element may be blurred at a peripheral part thereof. When the optical axis of the element is offset from the optical axis of a back focusing lens in a lens barrel, a resultant image can be out of focus. In this regard, in the semiconductor device 30, distortion of the heat conductive member 6 toward the semiconductor element 2 and resultant distortion of the semiconductor element 2 in the package 3 can be prevented because the screws 31 integral with the top surface 6a of the heat conductive member 6 are fastened with the nuts 34.

In the semiconductor devices 20 and 30 described above as second and third embodiments of the invention, the heat-radiating member 15 is secured to the heat conductive member 6 using screws. Such an approach is convenient for repair or maintenance because the heat-radiating member 15 can be easily removed.

### (Fourth Embodiment)

In the above-described first to third embodiments of the invention, it does not matter whether the material of the heat conductive member 6 has electrical conductivity or not as long as the material has high heat conductivity. When the heat conductive member 6 has electrical conductivity in addition to high heat conductivity, the potential of the heat conductive member 6 is indefinite. When the potential of the heat conductive member 6 is indefinite, noises in the form of static electricity or external electric waves can flow into the heat-radiating member 15 acting with an effect like that of an antenna, and the noises may not flow to the ground. In such a case, the noises can flow into the semiconductor element 2, for example, because of an electrostatic capacity formed by insulating substances included in the bottom portion 3c of the package 3 and the heat conductive adhesives 8 and 13 sandwiched between the semiconductor element 2 and the heat conductive member 6 as shown in Fig. 2.

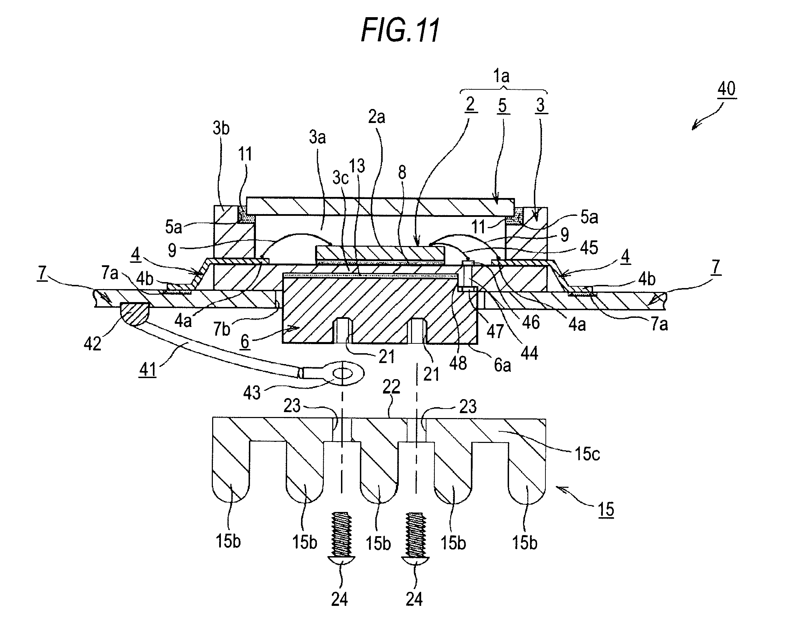

In a semiconductor device 40 shown in Figs. 11 to 13, a copper tungsten alloy is used as a heat conductive member 6 as described above to provide the member with high heat conductivity as well as electrical conductivity. In the semiconductor device 40, the heat conductive member 6 is electrically connected to a ground potential of a printed circuit board 7 using an earth cable 41. The semiconductor device 40 shown in Figs. 11 to 13 is an example in which a heat-radiating member 15 as shown in Figs. 7 and 8 is secured to the heat conductive member 6 by fastening screws 24 into screw holes 21 provided on the heat-radiating member 15. Alternatively, the heat-radiating member 15 of the semiconductor device 40 may be secured to the heat conductive member 6 by fastening screws 24 provided on the heat conductive member 6 with nuts 34 as shown in Figs. 9 and 10.

Specifically, as shown in Fig. 11, a printed circuit board 7 has a land 42 which is electrically connected to a ground potential and which is provided, for example, on a surface of the board opposite to a surface on which an assembly 1a formed by combining a semiconductor element 2, a light-transmitting plate 5, and a heat conductive member 6 with a package 3 is mounted, the land being located near the mounting position of the assembly 1a. One end of the earth cable 41 is soldered to the land 42 to be electrically connected to the same. A terminal portion 43 formed with a through hole is provided on another end of the earth cable 41. The terminal portion 43 is inserted between a top surface 6a of the heat conductive member 6 and the heat-radiating member 15, and the members are fastened together by inserting a screw 24 having electrical conductivity into the through hole.

As will be understood from the above, in the semiconductor device 40, external noises picked up by the heat-radiating member 15 can be guided to the land 42 connected to the ground potential of the printed circuit board 7 through the earth cable 41, whereby noises flowing into the semiconductor element 2 can be reduced.

One end of the earth cable 41 may alternatively be electrically connected to the land 42 using a screw having electrical conductivity or the like.

In general, the ground potential of the semiconductor element 2 is connected to the ground potential of the printed circuit board 7 by conductors 4. In a high operating frequency range, inductance components of wires 9 and the conductors 4 cannot be ignored, and it is difficult to keep the ground potential unaffected. According to the related art, the ground potential has been kept as close to a desired value as possible through a reduction in impedance achieved by increasing the number of conductors allocated to the ground potential and connecting them in parallel. In this case, however, the increase in the number of conductors 4 can result in a cost increase.

In the semiconductor device 40, the impedance of the ground potential of the semiconductor element 2 is reduced by connecting the heat conductive member 6 to the ground potential of the semiconductor element 2 and electrically connecting the heat conductive member 6 to the ground potential of the printed circuit board 7 using the earth cable 41.

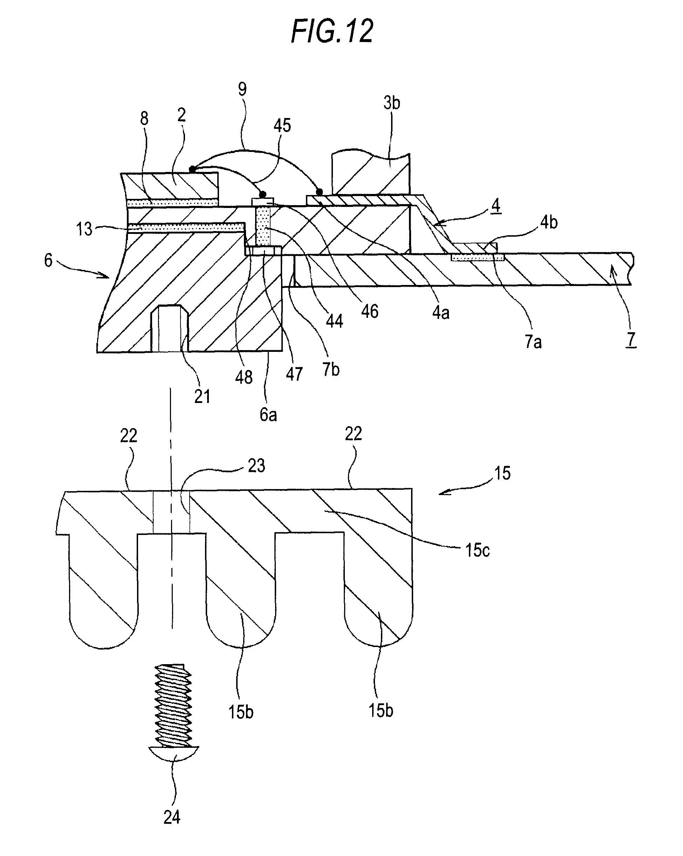

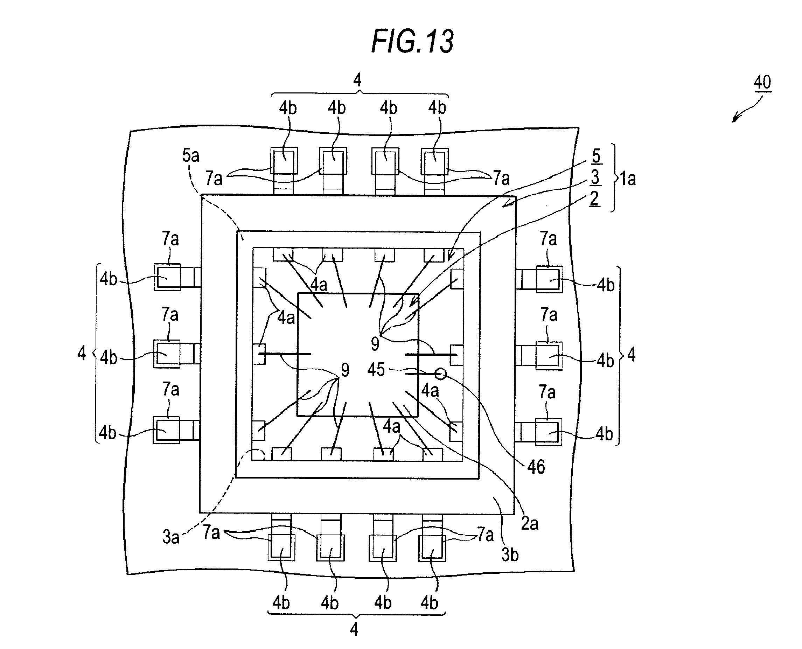

As shown in Figs. 12 and 13, one or a plurality of through holes 44 are formed in a peripheral part of a bottom portion 3c of the package 3 or around the semiconductor element 2. Specifically, the through hole 44 is formed around a mounting recess 12 of the package 3 provided for mounting the heat conductive member 6 and inside a circumferential wall 3b. The through hole 44 is filled with an electrically conductive material or plated on the circumferential wall thereof to electrically connect the surface having the semiconductor element 2 mounted thereon and the opposite surface. A first pad 46 to be electrically connected with a wire 45 is formed at the through hole 44 on the surface on which the semiconductor element 2 is formed. The wire 45 is provided to electrically connect a terminal of the semiconductor element 2 allocated to the ground potential and the first pad 46 using wire bonding. A second pad 47 to be electrically connected to the heat conductive member 6 having electrical conductivity is formed on the surface opposite to the surface on which the semiconductor element 2 is formed. The heat conductive member 6 has a cutout portion 48 formed to clear the peripheral part of the package 3, and the second pad 47 contact a surface of the cutout portion 48 to be electrically connected to the member 6. Thus, the ground potential of the semiconductor element 2 is electrically connected to the heat conductive member 6 via the through hole 44.

In the above-described semiconductor device 40, the heat conductive member 6 is electrically connected to the ground potential of the semiconductor element 2, and the heat conductive member 6 is also electrically connected to the ground potential of the printed circuit board 7 using the earth cable 41. Therefore, in the semiconductor device 40, the impedance of the ground potential of the semiconductor element 2 can be reduced while reducing the number of the conductors 4 rather than increasing the number of the conductors 4. The example in Fig. 13 shows six conductors 4 extending in the vertical direction as a result of a reduction from eight conductors 4 extending in the vertical direction in the above-described embodiments.

In the semiconductor device 40, the ground potential of the semiconductor element 2 is electrically connected via the through hole 44 formed in the package 3 to the heat conductive member 6 which is electrically connected to the ground potential of the printed circuit board 7. Therefore, the semiconductor element 2 of the semiconductor device 40 can be connected to the ground potential with mechanical rigidity higher than that achievable when the semiconductor element 2 is electrically connected to the ground potential of the printed circuit board 7 using the conductors 4. In the semiconductor device 40, the influence of external noises and electric waves radiated from the semiconductor element 2 itself can be suppressed. Further, in the semiconductor device 40, such an effect can be achieved simply by the operation of securing the heat-radiating member 15 to the heat conductive member 6 with the screws 24.

Assembly can be carried out with higher operability by securing the heat-radiating member 15 to the heat conductive member 6 with the screws 24 and connecting the semiconductor element 2 and the heat conductive member 6 to the ground potential of the printed circuit board 7 when compared to connecting a jumper wire to the heat conductive member 6 and the ground potential of the printed circuit board 7 using a soldering iron. The reason is that the temperature of solder cannot be easily increased to the melting point because of the low heat resistance of the heat conductive member 6 which causes the heat exerted by the soldering iron to diffuse toward the package 3. When it is attempted to raise the solder temperature using a high-power soldering iron, the temperature is rapidly transferred to the semiconductor element 2, and the heat can damage the semiconductor element 2.

When the heat-radiating member 15 is pressed into contact with the heat conductive member 6 using a spring or the like which is not shown instead of the screws 24 to connect it to the ground potential on the printed circuit board 7, the contact between the heat-radiating member 15 and the heat conductive member 6 can become unstable due to secular changes attributable to particles such as rust and sand caught in the gap between the members. In this case, the contact region can be vibrated by a vibration or shock coming from outside to cause a potential change attributable to the vibration frequency , and resultant noises may appear on an image output from the semiconductor element 2. Such a problem can be prevented in the semiconductor device 40 because the heat-radiating member 15 is secured to the heat conductive member 6 using screws.

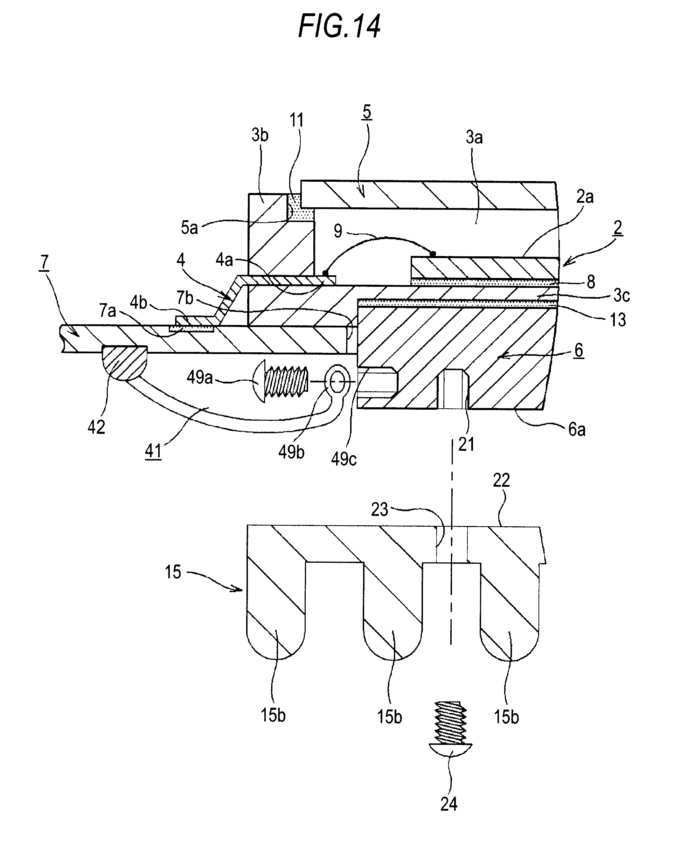

The above example has been described as an instance in which the end of the earth cable 41 having the terminal portion 43 is connected using a screw 24 as shown in Fig. 11. Alternatively, the end of the earth cable 41 may be electrically connected to the heat conductive member 6 using a screw 49a instead of the screw 24 as shown in Fig. 14. In this case, an electrically conductive washer 49b is provided at the end of the earth cable 41, and a screw hole 49c is provided, for example, on a side of the heat conductive member 6. The end of the earth cable 41 is electrically connected to the heat conductive member 6 by inserting the screw 49a into the washer 49b and fastening it into the screw hole 49c.

### (Fifth Embodiment)

The above-described embodiments have been described as instances in which heat generated at the semiconductor element 2 is thermally transferred from the heat conductive member 6 to the heat-radiating member 15 to radiate in a passive manner. Alternatively, cooling can be carried out in an active manner using both or either of a Peltier element and a cooling fan.

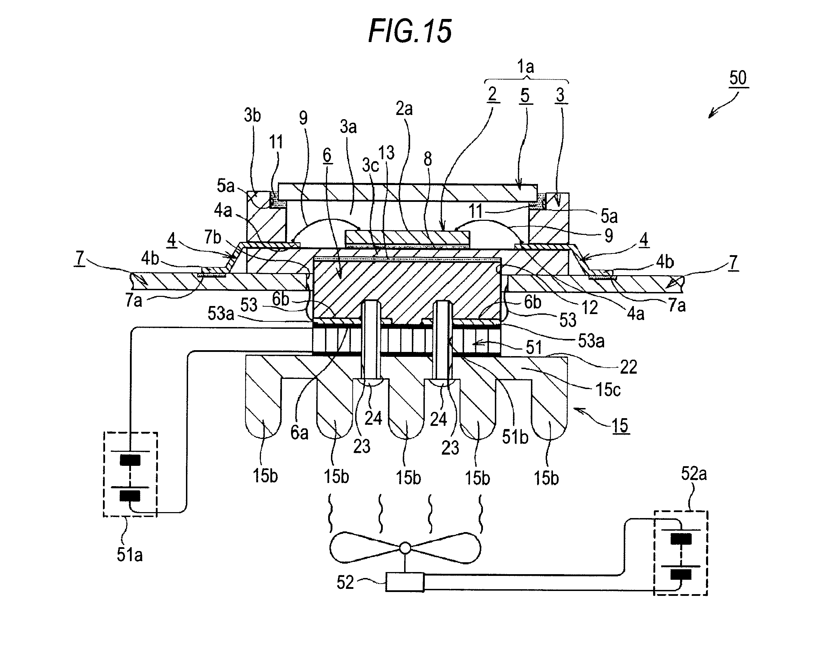

In a semiconductor device 50 shown in Fig. 15, a Peltier element 51 is mounted on a heat conductive member 6. A heat-radiating member 15 is mounted on the Peltier element 51. The heat-radiating member 15 is cooled by a cooling fan 52.

The heat conductive member 6 used in this device has one or a plurality of screw holes 21 provided on a top surface 6a thereof in the same way as in Figs. 7 and 8, and two screw holes are provided in this embodiment.

The Peltier element 51 has substantially the same size as the top surface 6a of the heat conductive member 6, and it is electrically connected to a DC power supply 51a. The element absorbs heat on its surface facing the heat conductive member 6 and radiates the heat from its surface facing the heat-radiating member 15. The Peltier element 51 is mounted such that the surface thereof facing the heat conductive member 6 abuts on the top surface 6a. The Peltier element 51 has mounting holes 51b, 51b formed to extend through the same in the thickness direction thereof in association with the screw holes 21, 21.

The heat-radiating member 15 is formed from a metal material having high heat radiating properties such as aluminum as described above. One surface of a base portion 15c of the member is formed flatly, and the surface constitutes a surface 22 to abut on the surface of the Peltier element 51 on the heat-radiating side thereof. A plurality of fins 15b are formed on the other side of the base portion 15c. Through holes 23, 23 are formed between respective pairs of adjoining fins 15 in association with the crew holes 21, 21 of the heat conductive member 6 and the mounting holes 51b, 51b of the Peltier element 51.

The heat-radiating member 15 is positioned by causing the abutting surface 22 to abut on the surface of the Peltier element 51 on the heat-radiating side thereof. Thereafter, the heat-radiating member 15 is secured with the top surface 6a and the abutting surface 22 kept in tight contact with each other by inserting the screws 24, 24 to serve as securing members into the through holes 23, 23 and the mounting holes 51b, 51b and fastening the screws into the screw holes 21, 21.

The Peltier element 51 and the heat-radiating member 15 may be mounted on the heat conductive member 6 by providing screws 31, 31 on the top surface 6a of the heat conductive member 6 as shown in Figs. 9 and 10, inserting the screws 31, 31 into the through holes 23, 23 and the mounting holes 51b, 51b, and fastening the screws 31, 31 with nuts 34, 34.

Further, the cooling fan 52 which is connected to the power supply 52a is disposed under the heat-radiating member 15. Thus, heat generated at the semiconductor element 2 of the semiconductor device 50 can be transferred by the Peltier element 51 to the heat-radiating member 15 through the heat conductive member 6 in an active manner, and the cooling fan 52 allows the heat to be radiation with high efficiency. Thus, the life of the semiconductor element 2 can be extended.

The semiconductor device 50 may include only the Peltier element 51 as an active cooling device with the cooling fan 52 excluded. Alternatively, the device may include only the cooling fan 52 with the Peltier element 51 excluded.

The semiconductor device 50 includes flexible boards 53 extending from inner layers of the printed circuit board 7 instead of the earth cable 41 shown in Figs. 11 and 14. The flexible boards 53 are electrically connected to the ground potential of the printed circuit board 7. Through holes to be pierced by the screw 24 are formed in rigid pads 53a provided at ends of the flexible boards 53. Cutout portions 6b which becomes a clearance of the pads 53a are formed on the top surface 6a of the heat conductive member 6. As shown in Fig. 15, the screws 24 are inserted through the pads 53a at the ends of the flexible boards 53 to mount the boards between the heat conductive member 6 and the Peltier element 51. The semiconductor device 50 as thus described can be provided with a simple configuration because there is no need for using the earth cable 41. Since the cutout portion 6b having a depth equivalent to the thickness of the pads 53a are provided on the top surface 6a of the heat conductive member 6, the surface for mounting the Peltier element 51 becomes substantially flat when the pads 53a are disposed at the cutout portions 6b. Thus, the Peltier element 51 can be mounted in a stable attitude in which the element is not shaken.

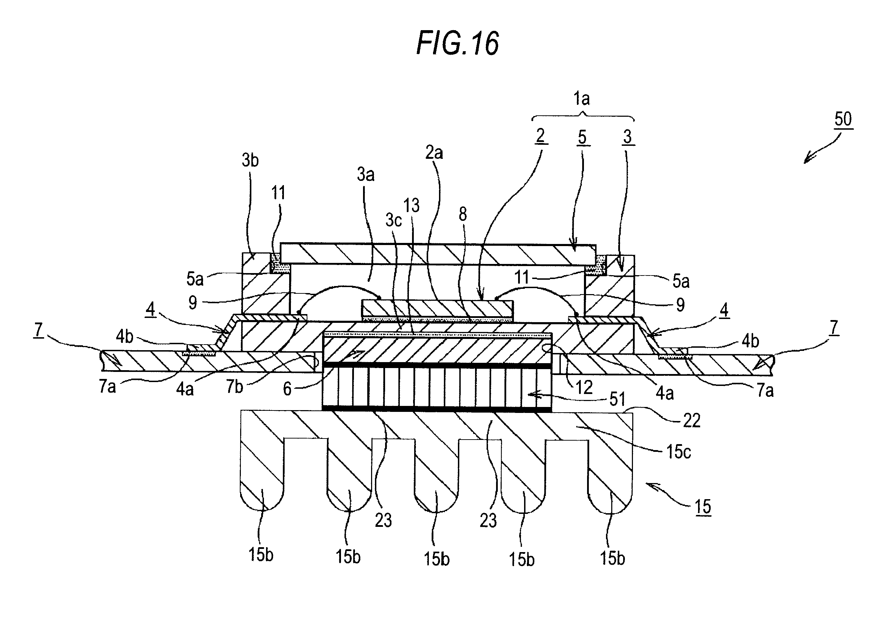

When the heat conductive member 6 and the Peltier element 51 are stacked, the stack of the heat conductive member 6 and the Peltier element 51 is required to have such a total thickness that the stack protrudes above the printed circuit board 7 as shown in Fig. 16. The heat conductive member 6, the Peltier element 51, and the heat-radiating member 15 may be mounted to the package 3 using screws as shown in Fig. 15, and they may alternatively be secured using a heat conductive adhesive although not shown. Thus, a heat-radiating member 15 greater than the mounting recess 12 can be mounted to the Peltier element 51.

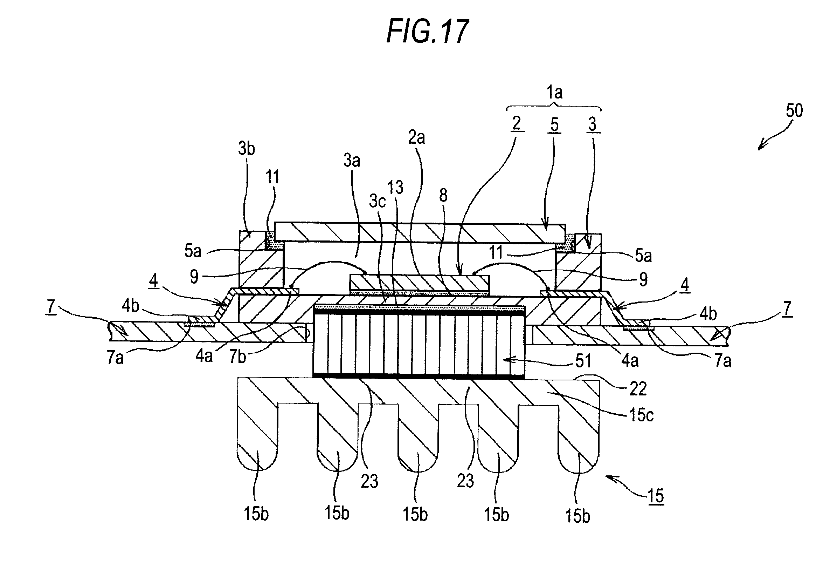

The above embodiments have been described as instances employing a heat conductive member 6 having high heat conductivity made of a copper tungsten alloy or the like, the Peltier element 51 may be used instead of such a heat conductive member 6 as shown in Fig. 17. Specifically, the Peltier element 51 may be directly mounted in the mounting recess 12 of the package 3. Although not shown, the Peltier element 51 and the heat-radiating member 15 may be mounted to the package 3 using screws, and they may alternatively be secured using a heat conductive adhesive. When the Peltier element 51 is mounted in the mounting recess 12, the Peltier element 51 functions as a heat conductive member 6 having high heat conductivity, and the heat of the semiconductor element 2 can be transferred to the heat-radiating member 15 without being transferred to the printed circuit board 7. The thickness of such a semiconductor device can be made smaller than that of a device in which the Peltier element 51 is stacked on the heat conductive member 6 as shown in Fig. 15.

### (Sixth Embodiment)

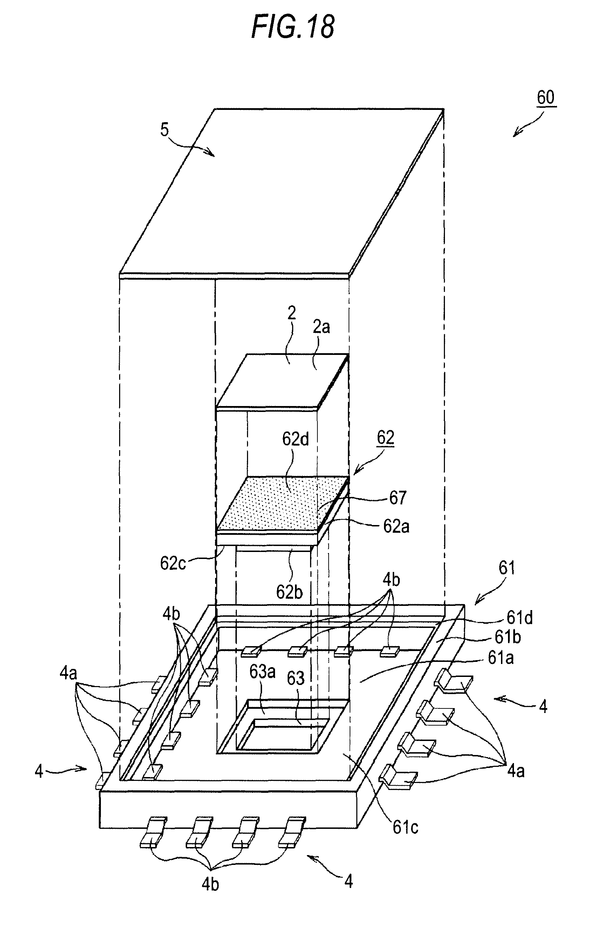

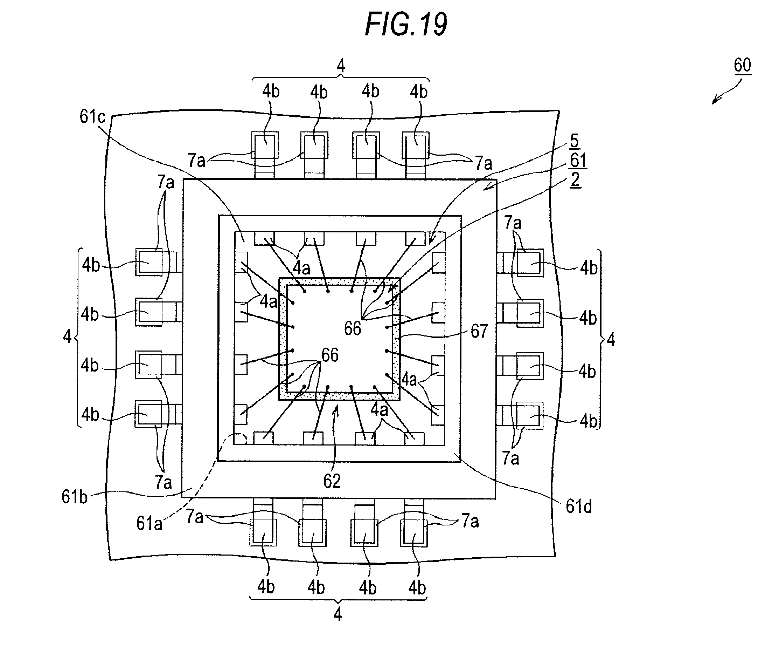

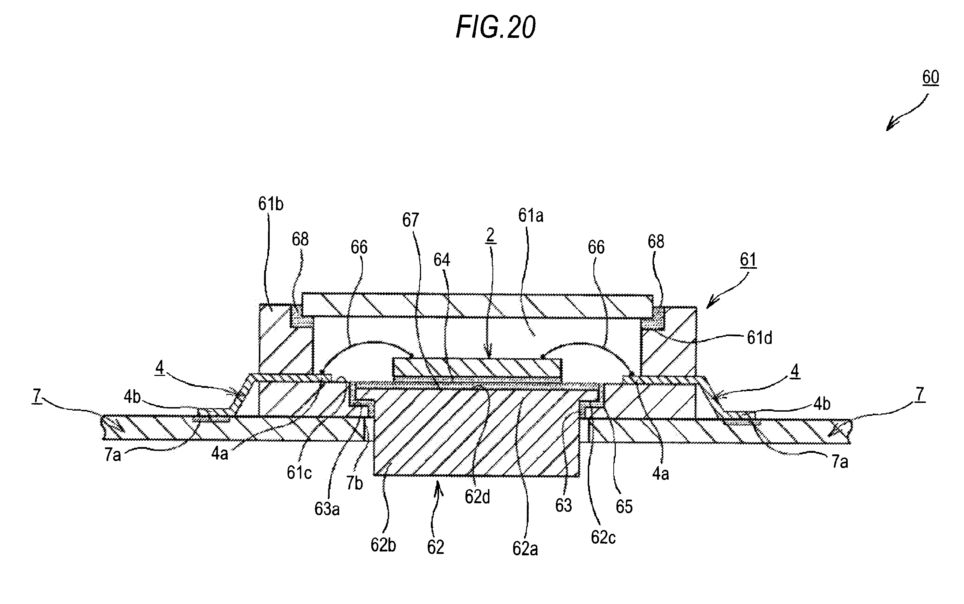

The above embodiments have been described as instances in which a mounting recess 12 is provided on a bottom portion 3c of a package 3 and in which a heat conductive member 6 is secured in the mounting recess 12. A mounting recess 12 may be formed to extend through a package to allow a semiconductor element 2 to be directly placed on a heat conductive member 6, as shown in Figs. 18 to 20.

Specifically, a package 61 of a semiconductor device 60 as an alternative to the above-described package 3 is formed from an electrically insulating material such as ceramic or epoxy resin. For example, the package 61 has a rectangular shape, and a recess 61a having, for example, a substantially rectangular shape is formed on one side of the package. Conductors 4 to serve as lead wires of a semiconductor element 2 are provided on a circumferential wall 61b forming part of the recess 61a, the conductors extending through the circumferential wall 61b from the inside of the same to the outside. Ends 4a of the conductors 4 located inside of the recess 61a are electrically connected to the semiconductor element 2, and ends 4b of the conductors located outside the recess 61a are electrically connected to an external circuit on a printed circuit board 7. The ends 4a of the conductors 4 located inside the recess 61a are electrically connected to terminals of the semiconductor element 2 by the wire 9.

A heat conductive member 62 on which the semiconductor element 2 is mounted is disposed at a bottom portion 61c of the package 61, and a mounting hole 63 is formed at the bottom portion to allow the heat conductive member 62 to be disposed. A supporting step portion 63a for supporting the heat conductive member 62 is formed around the mounting hole 63.

The heat conductive member 62 has a base portion 62a on which the semiconductor element 2 is secured and a heat conductive portion 62b which is formed integrally with the base portion 62a and on which a heat-radiating member 15 and a Peltier element 51 are secured. The heat conductive portion 62b is formed smaller than the base portion 62a, and the member 62 as a whole has a sectional shape which is substantially in the form of a stepped convex. The semiconductor element 2 is mounted on a principal surface 62d of the base portion 62a such that a light-receiving surface 2a of the element is located on the open side of the package 61 opposite to the side thereof on where the mounting hole 63 is provided. For example, the semiconductor element 2 is applied to the principal surface of the base portion 62a using an adhesive having low heat resistance, e.g., a heat conductive adhesive 64.

The heat conductive member 62 has an engaging step portion 62c formed around a junction between the base portion 62a and a heat conductive portion 62b, the engaging step portion 62c being engaged with the supporting step portion 63a formed around the mounting hole 63. The heat conductive member 62 is secured using an adhesive having low heat resistance, e.g., a heat conductive adhesive 65 with the supporting step portion 63a engaged with the engaging step portion 62c such that the light-receiving surface 2a of the semiconductor element 2 is located on the open side of the package 61 opposite to the side thereof where the mounting hole 63 is provided.

The principal surface 62d of the base portion 62a to which the semiconductor element 2 is applied has an area greater than that of the semiconductor element 2. Therefore, some parts of the principal surface 62d are exposed around the semiconductor element 2 when viewed from a light-entering side of the device. As a result, image quality may be degraded due to ghosting attributable to diffused reflections of incident light at the exposed parts of the principal surface 62d. For this reason, an insulation treatment and an anti-reflection treatment 67 is performed on the principal surface 62d of the base portion 62a, and the heat conductive adhesive 65 is applied to the resultant surface to bond the semiconductor element 2 to the same. The insulation treatment and the anti-reflection treatment 67 can be carried out by applying an insulation film and an anti-reflection film or performing a plating process or vacuum deposition on the surface.

In the semiconductor device 60, wire bonding is performed to electrically connect the semiconductor element 2 to the conductors 4 using wires 66. Thereafter, a light-transmitting plate 5 is mounted on the printed circuit board 7 by securing it using an adhesive 68 to the step portion 61d formed at the top of the circumferential wall 61b forming part of the recess 61a.

In the above-descried semiconductor device 60, since the semiconductor element 2 is directly mounted on the base portion 62a of the heat conductive member 62, heat generated at the semiconductor element 2 can be directly transferred to the heat conductive member 62.

The semiconductor device 60 may be provided with a Peltier element 51 and a cooling fan 52 as described above. The heat-radiating member 15 may be mounted to the heat conductive member 62 using screws, and the member 62 may be electrically connected to the ground potential of the printed circuit board 7 using an earth cable 41. The ground potential of the semiconductor element 2 may be connected to the heat conductive member 62.

### (7. Other Embodiments)

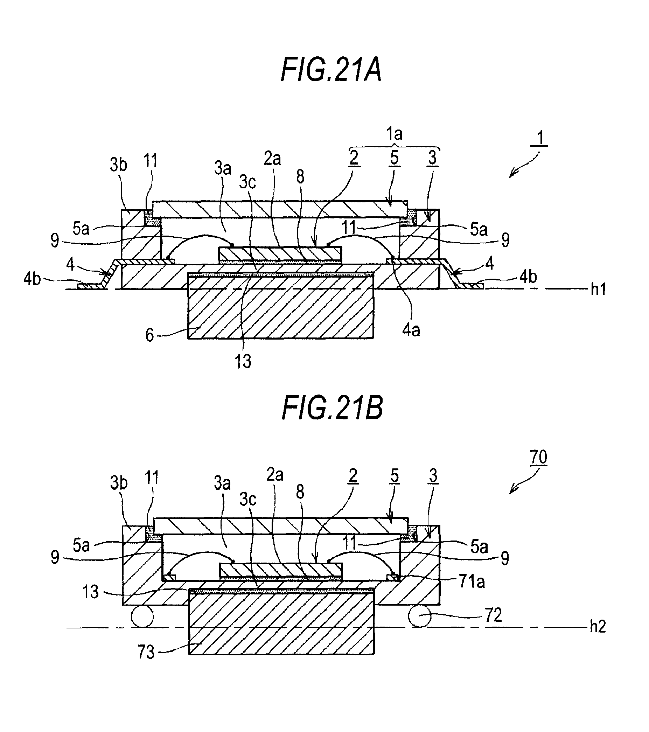

A description will now be made on the height of a heat conductive member 6 mounted on a printed circuit board 7 using a QFP (quad flat package) type package 3 as used in the first to sixth embodiments. Fig. 21A illustrates the semiconductor device 1 described above as the first embodiment of the invention by way of example. As shown in Fig. 21A, the ends 4b of the conductors 4 located outside the recess 3a of the QFP (quad flat package) type package are bent to become lower than the ends 4a located inside the recess 3a such that the ends 4b are put in contact with lands on the printed circuit board 7 located under the package 3. The heat conductive member 6 protrudes such that the top surface thereof is located below the height h1 of the ends 4b located outside the recess 3a, and the top surface is located in the opening 7b of the printed circuit board 7 serving as a clearance for the heat conductive member 6. Alternatively, the heat conductive member 6 may be formed with such a height that the member protrudes below the printed circuit board 7. Thus, heat generated at the semiconductor element 2 is not easily transferred to the printed circuit board 7, and the mounting of the heat-radiating member 15 is facilitated.

The invention may be implemented in a BGA (ball grid array) type semiconductor device 70 as shown in Fig. 21B which is mounted using terminals 72 in the form of metal balls or bumps provided on a bottom surface of a package 71. In this case, a semiconductor element 2 is electrically connected to pads 71a on a bottom surface of the package 71 using wires 74. The pads 71a are electrically connected to the terminals 72. A heat conductive member 73 applied to the bottom of the package 71 protrudes below the height h2 of the terminals 72 in the form of metal balls, and the heat conductive member 6 is located in an opening 7b of the printed circuit board 7 to serve as a clearance for the member. Alternatively, the heat conductive member 73 may be formed with such a height that the member protrudes below the printed circuit board 7. Thus, heat generated at the semiconductor element 2 is not easily transferred to the printed circuit board 7, and the mounting of a heat-radiating member 15 is facilitated.

### (8. Exemplary Applications)

The semiconductor devices 1, 20, 30, 40, 50, 60, and 70 with an imaging function embodying the present invention may be used in electronic apparatus having an imaging function. For example, the embodiments of the invention may be used as imaging sections of video cameras and still cameras. The embodiments of the invention may be used as imaging sections of telescopes and microscopes and as optical pickups of optical disk drives.

The present application contains subject matter related to that disclosed in Japanese Priority Patent Application JP 2009-072496 filed in the Japan Patent Office on March 24, 2009, the entire contents of which is hereby incorporated by reference.

It should be understood by those skilled in the art that various modifications, combinations, sub-combinations and alterations may occur depending on design requirements and other factors insofar as they are within the scope of the appended claims or the equivalents thereof.

## Claims

1. A semiconductor device comprising:
a semiconductor element having an imaging function, one surface of which serves as a light-receiving surface;
a package having a recess containing the semiconductor element with the light-receiving surface facing outward;
a light-transmitting plate closing the recess of the package containing the semiconductor element;
a conductor provided at the package, electrically connected to the semiconductor element, and electrically connected to an external circuit;
a heat conductive member provided to protrude from another surface of the semiconductor element; and
a printed circuit board on which the external circuit is provided, on which the semiconductor element is mounted in electrical connection with the external circuit, and which is formed with an opening to serve as a clearance for the heat conductive member.

2. A semiconductor device according to Claim 1, wherein a heat-radiating member is secured on a surface of the heat conductive member on the side opposite to the package using a securing member.

3. A semiconductor device according to Claim 1 or 2, wherein the heat conductive member is electrically conductive and electrically connected to a ground potential of the printed circuit board.

4. A semiconductor device according to Claim 3, wherein the heat conductive member is electrically connected to a ground potential of the semiconductor element.

5. A semiconductor device according to any of Claims 2 to 4, wherein the heat-radiating member is provided with a Peltier element.
